(19) Europäisches Patentamt
European Patent Office
Office européen des brevets

(11) EP 2 037 572 A1

(12) **EUROPEAN PATENT APPLICATION**

(43) Date of publication:
18.03.2009 Bulletin 2009/12

(51) Int Cl.:
*H03F 1/02* (2006.01)    *H03F 1/26* (2006.01)
*H03F 3/195* (2006.01)    *H03F 3/191* (2006.01)

(21) Application number: 07116606.0

(22) Date of filing: 17.09.2007

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **Seiko Epson Corporation**
**Shinjuku-ku**
**Tokyo 163-0811 (JP)**

(72) Inventors:
• **Gil Galí, Ignacio**
 **c/o EPSON EUROPE ELECTRONICS GmbH**
 **2a planta**
 **Sant Cugat del Vallés (Barcelona)08190 (ES)**
• **Cairo Molins, Josep Ignasi**
 **c/o EPSON EUROPE ELECTRONICS GmbH**
 **2a planta**
 **Sant Cugat del Vallés (Barcelona)08190 (ES)**

(74) Representative: **Carpintero Lopez, Francisco et al**
 **Herrero & Asociados, S.L.**
 **Alcalá 35**
 **28014 Madrid (ES)**

(54) **Ultra-low power consumption current-reused front-end for a RF system**

(57) The present invention is related to a front-end for radio frequency systems, which is based on a low power low noise amplifier (LNA) and at least one mixer stage. The LNA includes at least a first circuit branch comprising a first transistor (M1) and a second transistor (M2) connected in cascade configuration to amplify an input signal A LC tank is provided to choke signal transmission from the drain of the first transistor (M1) to the source of the second transistor (M2). The same current which supply the LNA is used also for the mixer transconductance stage to save power consumption.

FIG. 1

EP 2 037 572 A1

**Description**

**OBJECT OF THE INVENTION**

The present invention is related to a front-end for radio frequency systems, which is based on a low power low noise amplifier (LNA) and at least one mixer stage.

It is an object of the present invention to provide a front-end with high gain, low noise performance and ultra-low power consumption.

In a preferred embodiment, the invention refers to a single-ended to differential current-reused front-end, with double LC tank based on a transformer.

**BACKGROUND OF THE INVENTION**

Typically in a radio frequency system, the front-end block is formed by a Low Noise Amplifier (LNA) and a mixer block for mixing a signal amplified by the LNA with a local oscillator signal, to down convert the amplified signal to intermediate frequency. The design of a RF front-end is still a challenge, due to the need for very low power consumption devices in current wireless communication systems.

On the other hand, a LNA is typically used for RF receivers in wireless communication systems for obtaining power gain and reducing the noise factor. In typical radio receivers, the LNA is one of the most relevant devices of the system, due to its high influence in the total system noise figure, because the LNA is located at the input of the receiver chain and the overall noise figure of the receiver front end, is dominated by the first few stages, according Friis' formula, (eq. 1), sensitivity and power consumption of the system RF blocks.

$$NF_{TOT} = NF_1 + \frac{NF_2 - 1}{A_1} + \frac{NF_3 - 1}{A_1 \cdot A_2} + \ldots + \frac{NF_N - 1}{A_1 \cdot A_2 \cdots A_{N-1}} \qquad \text{eq. 1}$$

Where, $NF_{TOT}$ corresponds to the total noise figure system, whereas $NF_j$ and $A_j$ are the j-stage NF and available power gain, respectively.

Typically, the LNA achieve simultaneous input and output matching (in order to optimize gain) and good noise performance at any given amount of power dissipation. The advantage of the present invention is to allow these performances with a high gain and ultra-low power consumption. Also it includes the advantage to provide differential output which is very useful for commercial receivers (which typically have two branches i.e. I and Q branches).

The following references are related to the present invention:

J.A.M Jävinen, J. Kaukovuori, J. Ryynänen, J. Jussila. K. Kivekäs, M. Honkanen and K.A.I. Halonen, "2.4 Ghz receiver for sensor applications", IEEE Journal of solid-state circuits, Vol. 40, N° 7, July 2005.

H. Sjöland, A.Karimi-Sanjaani and A.A. Abidi, "A merged CMOS LNA and mixer for a WCDMA receiver", IEEE jounal of solid-state circuits, Vol 38, n° 6, pp 1045-1050, June 2003.

**SUMMARY OF THE INVENTION**

The front-end device of the present invention includes a current reuse topology, in such a manner that an amplifying stage of the LNA is also used as the transconductance stage of the mixer, so that an important power consumption saving is obtained because the same DC current is used to supply an amplifier of the LNA, and the transconductance stage of the mixer, both implemented by the same transistor stage.

In particular, one aspect of the invention refers to a radio-frequency front-end comprising a low noise amplifier including at least a first circuit branch, said first circuit branch comprising a first transistor and a second transistor, connected in cascaded configuration to amplify an input signal. A first LC tank is connected between the drain of a first transistor and the source of the second transistor of the LNA, so that the LC tank is calculated to choke signal transmission from the drain of the first transistor to the source of the second transistor. The signal to be amplified flows to the second transistor by its gate through a capacitor. The front-end further comprises a first mixer switching stage coupled to the second transistor, to mix an amplified signal with a local oscillator signal.

The signal amplified by the second transistor is applied to the RF port of the mixer, and it is mixed with the signal corresponding to a local oscillator port, in such a way that the output mixed signal corresponds to the IF port.

The tank is formed by an inductor, preferably of a transformer, and a capacitor connected in parallel, and the value of said equivalent inductor and capacitor are calculated to provide high impedance at the resonant frequency of the LC tank. The effective resonant frequency has been designed to provide a frequency in the vicinity of the operation range of the LNA (i.e. 2.45GHz).

In the present invention, it has been found that a LC tank implemented by a differential transformer and a capacitor connected in parallel and tuned at the desired frequency (for example 2.45 Ghz), advantageously avoids RF signal transmission between the drain of the first transistor and the source of the second transistor. The LC tank has an improved choke function compared with a conventional inductor, since higher impedance at resonance frequency of the LC tank in comparison to a single inductor is achieved.

Preferably, the LNA comprises two symmetric circuit branches to form a differential amplifier having a single input to differential output configuration. The second circuit branch comprises third and fourth transistors located in a cascade configuration, and a second LC tank connected between the third and fourth transistors to avoid signal transmission from the drain of the third transistor, to the source of the fourth transistor.

Preferably, the LNA is provided with a differential transformer, and the inductors of the first and second LC tanks, are the windings of said transformer so that avoids RF signal transmission, between the drains of the first and third transistors (first amplifying stage), and the sources of the second and fourth transistors (second amplifying stage).

The present invention compared with prior-art techniques, provides a front-end with an ultra-low power consumption and a high gain, due to the use of the LC tank implemented by means of a single to differential transformer between the first and the second gain stage, and due to the fact that the same current which supply the LNA is used also for the mixer transconductance stage.

**DESCRIPTION OF THE DRAWINGS**

The features of the invention will be better understood by reference to the accompanying drawings, which illustrate preferred embodiments of the invention.

Figure 1.- shows the topology of the front-end according to a preferred embodiment of the present invention.

Figure 2.- shows diagrams of the results obtained from the switching mixer block simulation. Diagram a: shows the input impedance, diagram b: shows the output IF signals, and diagrams c,d: show the input and output spectrum respectively.

Figure 3.- shows in figure 3 (a) a diagram of the total front-end gain, and in figure 3 (b) a diagram corresponding to the total front-end noise figure, depending on the local oscillator power.

**DETAILED DESCRIPTION OF PREFERRED EMBODIMENTS**

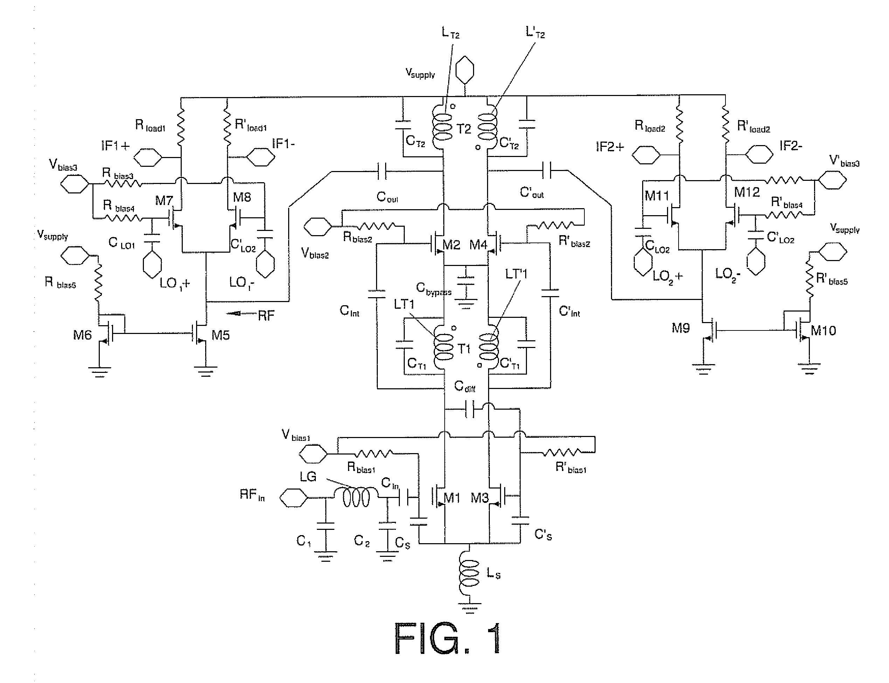

Figure 1 shows a preferred embodiment of the front-end according to the present invention, which is formed by a differential LNA and a mixer stage for each differential branch. The LNA comprises a first circuit branch formed by a first transistor (M1) and a second transistor (M2) located in cascade configuration to amplify an input signal.

The first and the second transistors (M1,M2) are arranged as common source transistors, and a first LC tank is connected between the drain of the first transistor (M1) and the source of the second transistor (M2), to choke a signal between said nodes of the first and second transistors.

The first LC tank is formed by a first inductor (Lt1), corresponding to a part of the transformer (T1) and a first tank capacitor (Ct1) connected in parallel, the value of said inductor, transformer coupling factor and capacitor being calculated to provide a high impedance at the resonant frequency of the LC tank. The ideal coupling factor of the transformer is 1, although in practical embodiments it may be less than 1, for instance 0.7.

The drain of the first transistor (M1) is coupled to the gate of the second transistor (M2) through a first capacitor (Cint) selected to apply or transfer a RF signal at the drain of the first transistor (M1), to the gate of the second transistor (M2).

An input terminal (RFin) to receive said input signal, is coupled to the gate of the first transistor (M1) through a matching network formed by a first and a second matching capacitors (C1,C2) and a matching inductor (Lg) connected in a π-configuration. Alternatively the matching network can be connected in a T-configuration. This matching network is used to obtain maximum power transference from the input terminal (RFin) to the LNA and to minimise noise power.

A series decoupling capacitor (Cin) is connected between the matching network and the gate of the first transistor (M1), in order to avoid DC contribution over the RF input.

In this preferred embodiment, the low noise amplifier comprises a first and second symmetric circuit branches to form a differential amplifier having a single input terminal (Rfin) and differential output terminals (Rfout+,Rfout-). Then, a second circuit branch comprises third and fourth transistors (M3,M4) coupled also in a cascaded configuration, are arranged as common source transistors. The drain of the third transistor (M3) is coupled to the gate of the fourth transistor (M4) through a second capacitor (Cint'), to transfer a RF signal to the gate of the fourth transistor (M4). As it can be observed in figure 1, after the first amplifying stage, the implementation of the amplifier is fully symmetrical to ensure a good differential performance of the amplifier.

A second LC tank, connected between the drain of the third transistor (M3) and the source of the fourth transistor (M4), is formed by a second inductor (Lt1'), corresponding to a part of the transformer (T1), and a second tank capacitor (Ct1') connected in parallel, which are calculated to provide a high impedance at the resonant frequency of the LC tank and avoid signal transmission between said nodes of the transistors.

The inductors of the first and second LC tanks are the windings of a differential transformer (T1), and two capacitors (Ct1,Ct1') are connected in parallel and are tuned at the desired frequency (in this case 2.45 GHz), to avoid RF signal transmission between (M2-M4) sources and (M1-M3) drains.

The gate of the third transistor (M3) is coupled to the drain of the first transistor (M1) by means of a third capacitor (Cdiff), which value is selected to copy the RF signal from one branch to the other one and at the same time to block the DC current.

First and second shunt capacitors (Cs,Cs') are respectively connected in shunt configuration with capacitance Cgs (capacitance gate-source) of transistors (M1) and (M3) in order to increase matching controllability and improve noise figure. In particular, shunt capacitors (Cs,Cs') are respectively connected between the gate and the source of the first and third transistors (M1,M3). Capacitors (Cs,Cs') are included in the input matching and allow a certain degree of controllability since they increase the effective Cgs of transistors (M1,M3).

The drains of the second and fourth transistors (M2,M4) are coupled respectively to output terminals (RFout+, RFout-), preferably by means of first and second output capacitors (Cout,Cout'), in order to avoid DC contribution over the differential output. The output terminals (RFout+, RFout-) provide a 180° differential output. These LNA output ports, correspond to the RF input ports for the mixer switching stage.

In this embodiment, the drains of the second and fourth transistors (M2,M4) are connected to a DC supply source through a second differential transformer (T2) formed by third and fourth coupled inductors (Lt2,Lt2'). This second transformer (T2) is used to provide output matching and to perform good 180° output differential signal.

More in detail, the third inductor (Lt2) is connected between the drain of the second transistor (M2) and the DC power supply, and the fourth inductor (Lt2') is connected between the drain of the fourth transistor (M4) and the power supply. Third and fourth inductors (Lt2,Lt2') are connected in parallel respectively with third and fourth tank capacitors (Ct2,Ct2') to form LC tanks respectively in the first and second circuit branches to avoid RF signal transmission to the DC power supply.

A bypass capacitor (Cbypass) is connected between ground and the sources of the second and fourth transistors (M2,M4). A large value of the bypass capacitor (Cbypass) is used to provide a reliable path to ground for the RF signal and to clearly differentiate the LNA function from the mixer function, since there is AC connection to ground from this (M2,M4) transistors, and thus they can play the role of the mixer transconductance stage.

The sources of the first and third transistors (M1,M3) are coupled to ground, through a degeneration inductor (Ls). The degeneration inductor (Ls) provides also another degree of freedom with regard to impedance matching. Moreover, it is designed to increase the impedance at node formed by (M1,M3) sources, because it improves the balanced gain and phase of the device. The reason to increase this node impedance is due to the fact that although the symmetric circuit configuration provides ideal 180° phase difference between branches, gain and phase could be degraded if this impedance node is not controlled.

In this amplifier the first and the third inductors (Lt1,Lt2) and the degeneration inductor (Ls), provide a dc current path from the dc power supply to ground. Similarly in the second circuit branch, the second and fourth inductors (Lt1', Lt2') and (Ls) also provide a dc current path from the dc power supply to ground. Therefore, in this arrangement the same DC current is used for the pair of transistors (M1-M2) and for the pair of transistors (M3-M4), therefore saving power compared with cascaded amplifiers topologies. The current for each branch is equivalent if they are designed symmetrically.

The second amplification stage formed by transistors (M2,M4) stacked over the first amplification stage (M1,M3), reduce the noise impact in the structure and increase the LNA gain. The circuit of this implementation is fully symmetrical from the first amplification stage to the voltage supply,

Transistor biasing is carried out in a conventional voltage bias manner. In particular, first and second biasing resistors (Rbias1,Rbias1') are connected respectively between the gate nodes of the first and third transistors (M1,M3) and a first biasing voltage terminal (Vbias1). Third and fourth biasing resistors (Rbias2,Rbias2') are connected respectively between the gate nodes of the second and fourth transistors (M2,M4) and a second biasing voltage terminal (Vbias2).

It is significant to note that the (M2-M4) stage may present the role of any cascade gain stage following a first amplifier formed by (M1-M3). In particular the (M2-M4) stage can play the role of the transconductance part of a following mixer device. In other words, this structure can be seen just as a LNA or a LNA with part of the mixer stage, by requiring the same power consumption.

A mixer stage is connected to each differential output of the LNA, and in particular to the drain of the second and fourth transistors (M2,M4) respectively by means of first and second output capacitors (Cout, Cout'), A first mixer stage comprises switching means connected to said first output capacitor (Cout), to receive an amplified signal from the LNA, and it is adapted to mix said amplified signal with a differential local oscillator signal, in order to down convert the amplified signal into an intermediate frequency differential signal.

The switching means are implemented by first and second source transistors (M7,M8) connected at their sources and having local oscillator ports (Lo1+,Lo1-) capacitively connected to their gates nodes by means of first and second mixer capacitances (CLO1,CLO1') as represented in figure 1.

The drains of the first and second source transistors (M7,M8) are connected to intermediate frequency ports (IF1+,IF1-), and to the DC power supply by means of first and second load resistors (Pload 1, Rload 1'). The value of the load resistors determine the gain of the mixers stages, which is added to the gain of the LNA.

First and second source transistors (M7,M8) are supplied by using a current mirror topology implemented by first and second current transistors (M5,M6), which have their gates nodes interconnected, and their source nodes connected to ground. The drain of the first current transistor (M5) is connected to the sources of the transistors (M7,M8) which in turn are connected to the capacitor (Cout) to receive the signal amplified by the LNA.

The drain of the second current transistor (M6) is connected to the DC power supply by means of a biasing resistor (Rbias5), and it is short-circuited to the gate node of the same transistor (M6).

In the right branch of the circuit, a second mixer stage with the same topology and function of the first mixer previously described, is connected to the drain of the fourth transistor (M4). The second mixer stage, comprises third and fourth source transistors (M11,M12) connected at their sources and having local oscillator ports (LO2+,LO2-) capacitively connected to their gates nodes by means of third and fourth mixer capacitances (CLO2,CLO2') as represented in figure 1.

The drains of the third and fourth source transistors (M11,M12) are connected to intermediate frequency ports (IF2+,IF2-), and to the DC power supply by means of third and fourth load resistors (Rload 2, Rload 2'). Transistors (M11,M12) are supplied by using current mirror implemented by third and fourth current transistors (M9,M10) which have their gates nodes connected and their source nodes connected to ground. The drain of the fourth current transistor (M9) is connected to the sources of the transistors (M11,M12), which in turn are connected to the capacitor (Cout).

The second transistor (M2) of the LNA is used as transconductance stage of the first mixer, for that the LNA and the mixer transconductance, are stacked in the same structure. Similarly, the fourth transistor (M4) acts as transconductance for the second mixer.

All mixer transistors biasing is carried out in a conventional manner by connecting power supply terminals (Vbias3,Vbias3') thorough biasing resistors (Rbias3,Rbias3',Rbias4, Rbias4') as shown in figure 1.

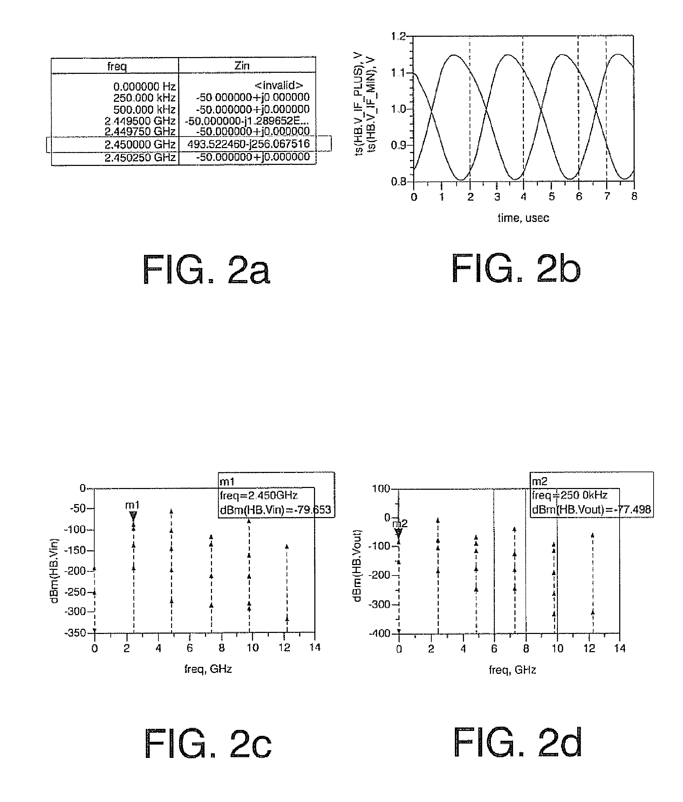

Some of the simulated results of the front-end device are illustrated in figure 2. Concerning the input spectrum the marker (ml) in figure 2 (c) depicts RF signal power at the input of the mixer switching stage, whereas the output spectrum shows the signal power of the IF signal by means of the marker (m2) in figure 2 (d). According to the values, it can be seen some gain (in the order of few dBs) because the main function of the switching stage is not to provide gain, but mix the involved signals. The amplification function is performed in the LNA previous stage and the transconductance mixer stage which constitutes the mentioned LNA. Together with these main signals there are conventional spurious spectra, due to the intrinsic non-linear behavior of the mixer.

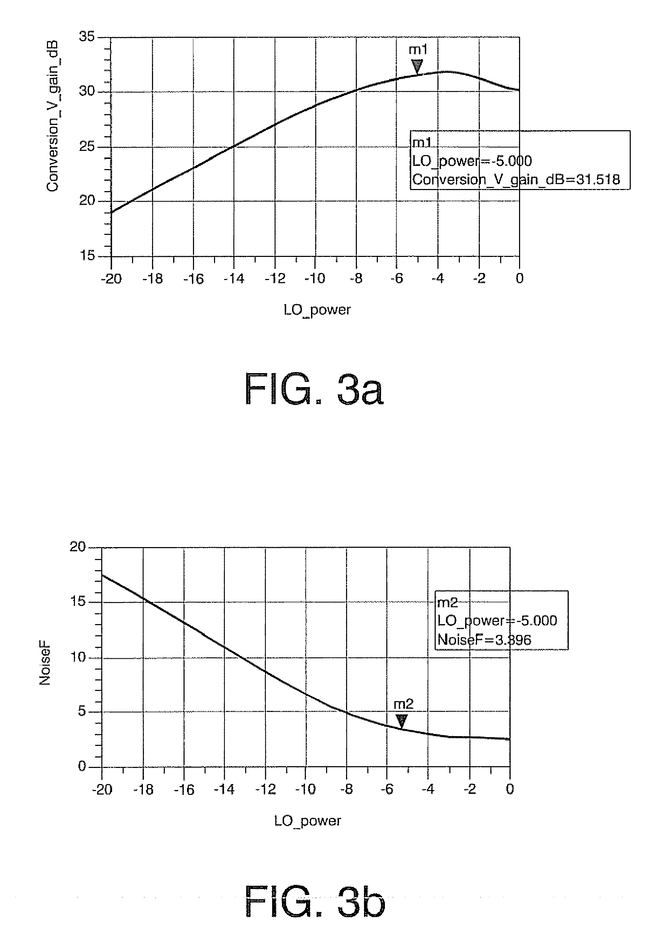

Figures 3 (a) and 3(b) show how the total front-end gain and noise depends also on the power value of local oscillator. Figs. 3 (a) and (b) depict this phenomena, typical for general mixer blocks. It is remarkable the total gain level achievable (more than 30 dB) and the total noise performance (lower than 5 dB) for conventional values of the LO port.

The invention also refers to an integrated circuit and to a wireless communication device, including a front-end according to the present invention.

The invention allows the use of a good quality transformer instead of a conventional inductor, thereby also reducing the surface required in a semiconductor die.

Further embodiments of the invention are described in the attached dependent claims.

The invention has been described according to some preferred embodiments of it, but for a skilled person in the art, it will be clear that many variations may be made to the preferred embodiments without departing from the object of the claimed invention.

**Claims**

1. A radio-frequency front-end comprising a
   low noise amplifier including at least a first circuit branch, said first circuit branch comprising a first transistor (M1) and a second transistor (M2) connected in cascaded configuration to amplify an input signal,

a first LC tank connected between the drain of the first transistor (M1) and the source of the second transistor (M2), wherein the LC tank is calculated to choke signal transmission,
a mixer coupled to the second transistor (M2), to mix the signal amplified by the low noise amplifier with a local oscillator signal.

2. A radio-frequency front-end according to claim 1 wherein the first and the second transistors (H1,M2) are arranged as common source transistors.

3. A radio-frequency front-end according to claim 1 or claim 2 wherein the drain of the first transistor (M1) is coupled to the gate of the second transistor (M2) through a first capacitor (Cint) selected to apply a signal at the drain of the first transistor to the gate of the second transistor.

4. A radio-frequency front-end according to any of the preceding claims wherein it comprises an input terminal(RFin) to receive said input signal, and wherein said input terminal is coupled to the gate of the first transistor (M1).

5. A radio-frequency front-end according to claim 4 wherein said input terminal is connected to the gate of the first transistor through a matching network, said matching network comprising a first and second matching capacitors (C1,C2) and a matching inductor (Lg) connected in a n-configuration or in a T-configuration.

6. A radio-frequency front-end according to claim 4 or 5 wherein the matching network is connected between said input terminal (Rfin) and the gate of the first transistor.

7. A radio-frequency front-end according to claim 6 wherein a series capacitor (Cin) is connected between the matching network and the gate of the first transistor, to avoid DC contribution over the RF input.

8. A radio-frequency front-end according to any of the preceding claims, wherein a bypass Capacitor (Cbypass) is connected to the source of the second transistor (M2).

9. A radio-frequency front-end according to any of the claims 1 to 7 wherein it comprises a first and second symmetric circuit branches to form a differential amplifier having a single input terminal (Rfin) and differential output terminals (Rfout+,Rfout-).

10. A radio-frequency front-end according to claim 9 wherein the second circuit branch comprises third and fourth transistors (M3,M4) connected in a cascade configuration and arranged as common source transistors, wherein the drain of the third transistor (M3) is coupled to the gate of the fourth transistor (M4) through a second capacitor (Cint'), and wherein a second LC tank is connected between the drain of the third transistor (M3) and the source of the fourth transistor (M4).

11. A radio-frequency front-end according to claim 10 wherein the gate of the third transistor (M3) is coupled to the drain of the first transistor (M1) by means of a third capacitor (Cdiff).

12. A radio-frequency front-end according to claim 10 or 11 wherein a first and a second shunt capacitors (Cs,Cs') are respectively connected between the gate and the source of the first and third transistors (M1,M3).

13. A radio-frequency front-end according to any of the preceding claims wherein the first LC tank is formed by a first inductor (Lt1) and a first tank capacitor (Ct1) connected in parallel, the LC tank being calculated to provide high impedance at the resonant frequency of the LC tank to avoid signal transmission.

14. A radio-frequency front-end according to any of the claims 10 to 13 wherein the second LC tank is formed by a second inductor (Lt1') and a second tank capacitor (Ct1') connected in parallel, the LC tank being calculated to provide a high impedance at the resonant frequency of the LC tank to avoid signal transmission.

15. A radio-frequency front-end according to claims 13 and 14 wherein the first and the second inductors (Lt1,Lt1') are the windings of a first transformer (T1).

16. A radio-frequency front-end according to claim 10 wherein the sources of the first and third transistors (M1,M3) are connected to ground through a degeneration inductor (Ls).

**17.** A radio-frequency front-end according to any of the claims 10 to 16, wherein the drains of the second and fourth transistors (M2,M4) are supplied by a DC source.

**18.** A radio-frequency front-end according to claim 10 wherein the drains of the second and fourth transistors are connected to a DC supply through a second differential transformer (T2) formed by third and fourth inductors (Lt2,Lt2').

**19.** A radio-frequency front-end according to claim 10 wherein the third inductor (Lt2) is connected between the drain of the second transistor (M2) and the DC power supply, and the fourth inductor (M4) is connected between the drain of the fourth transistor (M4) and the power supply.

**20.** A radio-frequency front-end according to claim 18 or 19 wherein third and fourth inductors (Lt2,Lt2') are connected in parallel respectively with third and fourth capacitors (Ct2,Ct2') to form a LC tank in the first and second circuit branches, to provide a RF choke.

**21.** A radio-frequency front-end according to any of the claims 10 to 20 wherein a bypass capacitor (Cbypass) is connected between ground and the sources of the second and fourth transistors (M2,M4), to provide a path to ground for the RF signal.

**22.** A radio-frequency front-end according to any of the preceding claims wherein a first mixer is coupled to the drain of the second transistor (M2) by means of a first output capacitor (Cout).

**23.** A radio-frequency front-end according to claim 22 wherein the mixer comprises switching means which are adapted to mix a local oscillator signal with the signal at the drain of the second transistor (M2).

**24.** A radio-frequency front-end according to any of the claims 1 to 21 wherein a second mixer is coupled to the drain of the fourth transistor (M4) by means of a second output capacitor (Cout').

**25.** A radio-frequency front-end according to claim 24 wherein the mixer comprises switching means which are adapted to mix a local oscillator signal with the signal at the drain of the fourth transistor (M4).

**26.** A radio-frequency front-end according to any of the preceding claims wherein it is adapted to operate within a band having a central frequency of approximately 2.45 GHz,

**27.** Integrated circuit having a semiconductor die including at least one front-end as defined in any of the claims 1 to 26.

**28.** Wireless communication device including a front-end as defined in any of the claims 1 to 26.

FIG. 1

| freq | Zin |
|---|---|
| 0.000000 Hz | <invalid> |
| 250.000 kHz | -50.000000+j0.000000 |
| 500.000 kHz | -50.000000+j0.000000 |
| 2.449500 GHz | -50.000000-j1.289652E... |
| 2.449750 GHz | -50.000000+j0.000000 |
| 2.450000 GHz | 493.522460-j256.067516 |
| 2.450250 GHz | -50.000000+j0.000000 |

FIG. 2a

FIG. 2b

FIG. 2c

FIG. 2d

9

## FIG. 3a

## FIG. 3b

**European Patent Office**

**EUROPEAN SEARCH REPORT**

Application Number

EP 07 11 6606

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DEVLIN L M ET AL: "A 2.4 GHz single chip transceiver" MICROWAVE AND MILLIMETER-WAVE MONOLITHIC CIRCUITS SYMPOSIUM, 1993. DIGEST OF PAPERS., IEEE 1993 ATLANTA, GA, USA 14-15 JUNE 1993, NEW YORK, NY, USA,IEEE, US, 14 June 1993 (1993-06-14), pages 23-26, XP010069076 ISBN: 0-7803-1322-4 * page 23, left-hand column, line 18 - page 24, left-hand column, line 15; figures 2,3 * | 1-8,13, 22-28 | INV. H03F1/02 H03F1/26 H03F3/195 H03F3/191 |
| X | LIAO C-H ET AL: "A 5.7-GHZ 0.18-MUM CMOS GAIN-CONTROLLED DIFFERENTIAL LNA WITH CURRENT REUSE FOR WLAN RECEIVER" IEEE MICROWAVE AND WIRELESS COMPONENTS LETTERS, IEEE SERVICE CENTER, NEW YORK, NY, US, vol. 13, no. 12, December 2003 (2003-12), pages 526-528, XP001190047 ISSN: 1531-1309 | 1-9,13, 22-28 | |
| Y | * page 526, left-hand column, line 12 - page 527, left-hand column, line 18; figure 1 * | 10-12, 14-21 | TECHNICAL FIELDS SEARCHED (IPC) H03F |
| Y | US 6 366 171 B1 (LITMANEN PETTERI M [US] ET AL) 2 April 2002 (2002-04-02) * column 7, lines 21-61; figure 7 * | 10-12, 14-21 | |
| Y | US 2003/141953 A1 (HASLETT JAMES WILLIAM [CA] ET AL) 31 July 2003 (2003-07-31) * paragraphs [0054] - [0063]; figures 8a,8b,9a,9b * | 15,18,20 | |

-/--

The present search report has been drawn up for all claims

| Place of search | Date of completion of the search | Examiner |
|---|---|---|
| The Hague | 8 January 2008 | Fedi, Giulio |

European Patent
Office

**EUROPEAN SEARCH REPORT**

Application Number

EP 07 11 6606

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 133 793 A (LAU SIN KAI HENRY [US] ET AL) 17 October 2000 (2000-10-17) * column 2, line 4 - column 3, line 44; figures 1,2 * ----- | 1,8,13, 22-28 | |
| X | US 2002/084855 A1 (KWON ICK JIN [KR] ET AL) 4 July 2002 (2002-07-04) * paragraphs [0033] - [0038]; figure 6 * ----- | 1-4,8,13 | |
| A | US 6 232 848 B1 (MANKU TAJINDER [CA]) 15 May 2001 (2001-05-15) * column 4, lines 38-57; figures 6,7 * ----- | 1-28 | |
| A | SUN M-C ET AL: "A ONE-STEP INPUT MATCHING METHOD FOR CASCODE CMOS LOW-NOISE AMPLIFIERS" IEICE TRANSACTIONS ON ELECTRONICS, ELECTRONICS SOCIETY, TOKYO, JP, vol. E88-C, no. 3, March 2005 (2005-03), pages 420-428, XP001226017 ISSN: 0916-8524 * page 423, left-hand column, line 23 - page 424, left-hand column, line 56; figures 7-9 * ----- | 1-28 | |

TECHNICAL FIELDS
SEARCHED (IPC)

The present search report has been drawn up for all claims

| Place of search | Date of completion of the search | Examiner |
|---|---|---|
| The Hague | 8 January 2008 | Fedi, Giulio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 11 6606

This annex lists the patent family members relating to the patent documents cited in the above-mentioned European search report.
The members are as contained in the European Patent Office EDP file on
The European Patent Office is in no way liable for these particulars which are merely given for the purpose of information.

08-01-2008

| Patent document cited in search report | | Publication date | Patent family member(s) | | Publication date |
|---|---|---|---|---|---|
| US 6366171 | B1 | 02-04-2002 | NONE | | |
| US 2003141953 | A1 | 31-07-2003 | NONE | | |
| US 6133793 | A | 17-10-2000 | NONE | | |
| US 2002084855 | A1 | 04-07-2002 | KR 20020055473 A | | 09-07-2002 |
| US 6232848 | B1 | 15-05-2001 | CA 2224953 A1 | | 16-06-1999 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **J.A.M JÄVINEN ; J. KAUKOVUORI ; J. RYYNÄNEN ; J. JUSSILA ; K. KIVEKÄS ; M. HONKANEN ; K.A.I. HALONEN.** 2.4 Ghz receiver for sensor applications. *IEEE Journal of solid-state circuits,* July 2005, vol. 40 (7

- **H. SJÖLAND ; A.KARIMI-SANJAANI ; A.A. ABIDI.** A merged CMOS LNA and mixer for a WCDMA receiver. *IEEE jounal of solid-state circuits,* June 2003, vol. 38 (6), 1045-1050